Europäisches Patentamt

European Patent Office

Office européen des brevets

(11) Numéro de publication : **0 462 654 B1**

(12)

# FASCICULE DE BREVET EUROPEEN

(45) Date de publication du fascicule du brevet :
**29.11.95 Bulletin 95/48**

(51) Int. Cl.⁶ : **H04L 25/30,** H04L 25/49,
H04N 7/00, G01R 19/165

(21) Numéro de dépôt : **91201462.8**

(22) Date de dépôt : **13.06.91**

(54) **Procédé de réglage d'un décodeur à seuil pour un signal à plusieurs niveaux et récepteur de télévision muni d'un tel décodeur.**

(30) Priorité : **19.06.90 FR 9007649**

(43) Date de publication de la demande :
**27.12.91 Bulletin 91/52**

(45) Mention de la délivrance du brevet :
**29.11.95 Bulletin 95/48**

(84) Etats contractants désignés :
**DE FR GB SE**

(56) Documents cités :
**US-A- 4 034 340**
**PATENT ABSTRACTS OF JAPAN vol. 10, no.**
**113 (E-399)(2170) 26 Avril 1986 & JP-A-60 249**
**447 (KOBUSAI DENSHIN DENWA K. K. ) 10**
**Décembre 1985**

(73) Titulaire : **PHILIPS ELECTRONIQUE GRAND**
**PUBLIC**
**51, Rue Carnot**
**F-92150 Suresnes (FR)**
(84) **FR**
Titulaire : **Philips Electronics N.V.**
**Groenewoudseweg 1**
**NL-5621 BA Eindhoven (NL)**
(84) **DE GB SE**

(72) Inventeur : **Lafon, Philippe**
**Société Civile S.P.I.D.,**
**156, Boulevard Haussmann**
**F-75008 Paris (FR)**

(74) Mandataire : **Caron, Jean et al**
**Société Civile S.P.I.D.**
**156, Boulevard Haussmann**
**F-75008 Paris (FR)**

## Description

La présente invention concerne un procédé pour le réglage du seuil d'un décodeur à seuil pour un signal à plusieurs niveaux.

L'invention concerne aussi un récepteur de télévision comportant des moyens de mesure du taux d'erreur binaire présent à la sortie du décodeur, et un microprocesseur.

Le document US-A-4 034 340 décrit un circuit avec un décodeur à seuil, dont le seuil est fixé à une valeur médiane par rapport à l'amplitude du signal. Il comprend aussi un décodeur à seuil ajustable, lequel est asservi. Le circuit décrit par ce document sert à mesurer la qualité du signal : il utilise, à côté du décodeur principal normal à seuil fixe, un autre décodeur accessoire dont le seuil est volontairement décalé, ce qui crée des "pseudo-errors", et le décalage du seuil décalé est asservi de façon à obtenir un nombre prédéterminé de différences entre les signaux décodés par l'un et par l'autre décodeur. La valeur du décalage entre les deux seuils ainsi obtenue constitue une mesure de la qualité du signal disponible, qui sert à actionner un indicateur visuel, un enregistreur ou un circuit d'alarme. Il s'agit donc d'un circuit destiné à mesurer la qualité d'un signal, et non à minimiser le taux d'erreur, comme dans la présente invention. En outre le circuit en question asservit un taux de pseudo-erreurs artificielles, mais le document indique clairement que le meilleur seuil pour le décodage des signaux utiles est un seuil fixe et médian par rapport au signal à décoder. Ce document ne prend pas en compte le comportement en présence d'échos.

Selon le procédé décrit par le document JP-A-60 249 447, on donne des caractéristiques particulières, exprimées par des relations mathématiques, aux circuits de mesure du niveau de signal. Ceci ne permet pas de régler au mieux le seuil du décodeur à seuil, notamment parce qu'on prend en compte le niveau du signal et non pas sa qualité (rapport signal/bruit). En outre le seuil du décodeur à seuil est réglé sans prendre en compte le comportement en présence d'échos.

L'invention fournit un moyen d'utiliser au mieux les possibilités d'un décodeur à seuil, lorsque le signal est perturbé par des échos quasi-stationnaires. Elle s'applique donc typiquement dans le cas de réseaux de distribution par câble, par exemple dans un standard MAC, pour le réglage optimal de chaque récepteur.

Les échos produisent sur l'image des défauts directement visibles, et aussi un bruit dit "de clamp" extrêmement gênant, surtout pour les échos longs. Sur les données binaires, ils entraînent une dégradation du taux d'erreurs.

Pour améliorer le comportement des décodeurs en présence d'échos, il est connu d'utiliser un égaliseur. L'efficacité d'un tel dispositif n'est pas contestée, mais ce genre de dispositif est assez coûteux.

L'invention s'appuie sur l'idée que le réglage optimal du seuil du décodeur réalisé avec un signal bruité mais non affecté d'échos, n'est peut-être pas le meilleur en présence d'échos.

Ainsi le procédé selon l'invention est remarquable en ce que, pour diminuer les nuisances dues à un signal d'entrée dans le décodeur affecté d'écho, on utilise un décodeur dont la valeur du seuil est programmable, et on adapte le seuil du décodeur, en déterminant le meilleure valeur de seuil à partir de plusieurs résultats de mesure, fournis par des moyens de mesure du taux d'erreur binaire en sortie du décodeur, et correspondant chacun à une valeur de seuil différente.

L'amélioration du réglage du seuil de décodage en présence d'échos n'a aucune action négative sur l'image, mais procure en général une amélioration du taux d'erreurs, variable selon le type d'écho, et qui peut aller jusqu'à deux ordres de grandeur, notamment dans le cas d'échos courts et puissants. En outre, le procédé reste avantageux même lorsqu'en plus on fait usage d'un égaliseur, car il permet de corriger certains défauts que l'égaliseur ne corrige pas.

Dans une forme particulière, le procédé de l'invention est remarquable en ce que, partant d'une valeur déterminée du seuil, on mesure le taux d'erreur binaire correspondant et on calcule à partir de ce taux d'erreur binaire une valeur appelée critère et qui est supérieure au taux d'erreur binaire et que l'on mémorise, puis on incrémente la valeur du seuil du décodeur pas à pas et à chaque pas on mesure le taux d'erreur binaire et on le compare au critère et s'il est plus petit que le critère on continue l'incrémentation alors que lorsque le taux d'erreur binaire devient pour la première fois plus grand que le critère on mémorise la valeur du seuil et on inverse le sens de l'incrémentation et enfin lorsque le taux d'erreur binaire devient pour la deuxième fois plus grand que le critère, on arrête l'incrémentation en mémorisant la dernière valeur du seuil et on choisit pour valeur de réglage du seuil la demi somme des deux valeurs de seuil respectivement au moment ou l'on a inversé le sens de l'incrémentation et au moment de l'arrêt de l'incrémentation.

On peut choisir avantageusement comme valeur numérique de pas d'incrémentation du seuil une valeur supérieure au pas le plus fin prévu pour le décodeur. Bien entendu le pas d'incrémentation de départ peut être aussi bien positif que négatif, c'est-à-dire que l'incrémentation peut être une décrémentation.

On obtient ainsi rapidement un ordre de grandeur du seuil qui est déja utilisable avec profit : on s'affranchit des problèmes de précision de mesure, et on obtient la valeur dont la probabilité d'être la meilleure est grande. En outre on n'a jamais constaté expérimentalement de divergences au cours d'un tel processus.

Il est avantageux que lors de la mesure du taux d'erreur binaire au départ du processus, on mémorise sa valeur que l'on suppose pour l'instant être le taux d'erreur binaire optimal et qu'ensuite, à chaque pas d'incrémentation, on compare le taux d'erreur mesuré avec le taux d'erreur binaire optimal et si le taux d'erreur binaire mesuré est plus petit que le taux d'erreur binaire optimal on remplace en mémoire la valeur du taux d'erreur binaire optimal par la nouvelle valeur mesurée à l'instant et on recalcule et mémorise aussi un nouveau critère avant de continuer l'incrémentation.

Ainsi la valeur du critère devient meilleure au cours du processus et est mieux adaptée pour une étape suivante, qui peut accroître encore de façon appréciable l'optimisation du réglage et dans laquelle on met en oeuvre un deuxième processus analogue au premier, deuxième processus dans lequel on utilise comme critère le dernier critère calculé lors du premier processus et comme valeur de départ pour le seuil la dernière valeur du seuil utilisée dans le premier processus, puis on incrémente la valeur du seuil du décodeur pas à pas avec un pas plus petit que lors du premier processus et à chaque pas on mesure le taux d'erreur binaire et on le compare au critère et lorsque le taux d'erreur binaire devient plus petit que le critère on mémorise une première valeur qui est celle du seuil à cet instant et lorsque le taux d'erreur binaire devient plus grand que le critère on arrête l'incrémentation en mémorisant une deuxième valeur qui est celle du seuil à cet instant et on choisit pour valeur de réglage du seuil la demi-somme des susdites première et deuxième valeurs de seuil.

Pour ce deuxième processus on peut choisir avantageusement comme valeur numérique du pas d'incrémentation du seuil la valeur la plus fine prévue pour le décodeur. On obtient ainsi une valeur précise sans dépense de temps excessive malgré le pas plus petit, parce que le critère est plus petit qu'au début du premier processus. Pour éxécuter les deux étapes de processus ci-dessus, le temps de réglage avec les matériels disponibles aujourd'hui est d'environ une minute.

Dans toutes les étapes de processus où le calcul du critère intervient, ce dernier est calculé en ajoutant une première quantité fixe à la valeur du taux d'erreur mesuré, et en multipliant le tout par une deuxième quantité fixe.

A titre de sécurité, il est bon de vérifier que le taux d'erreur binaire résiduel après réglage est inférieur au critère et dans le cas contraire, de recommencer tout le processus. Notamment ceci peut être fait à chaque allumage d'un récepteur dont le décodeur est réglé de cette façon.

Lorsque les échos sont en général les mêmes à chaque utilisation du décodeur, par exemple dans le cas de réseaux cablés, il est avantageux de mémoriser la valeur de réglage trouvée pour chacune des émissions susceptibles d'être reçues par le décodeur. Ainsi il n'est pas nécessaire de reprendre le processus de réglage à chaque fois que l'on change d'émission.

Un récepteur selon l'invention est remarquable en ce qu'il est muni d'un décodeur à seuil avec une entrée numérique de commande pour y établir une valeur de seuil, et en ce que le microprocesseur comporte un programme pour déterminer, à partir de plusieurs résultats de mesure, fournis par lesdits moyens de mesure du taux d'erreur binaire et correspondant chacun à une valeur de seuil différente, une valeur numérique de réglage optimal du seuil du décodeur et pour la fournir à ladite entrée numérique de commande.

Le récepteur comprend en outre avantageusement des positions de mémoire permanente pour stocker des valeurs de réglage de seuil.

La description qui va suivre, en regard des dessins annexés décrivant des exemples non limitatifs fera bien comprendre comment l'invention peut être réalisée.

La figure 1 est un schéma synoptique d'un dispositif pour mettre en oeuvre le procédé, dispositif dont est muni un récepteur de télévision selon l'invention.

Les figures 2 et 3 sont des diagrammes du taux d'erreur (BER) en fonction du seuil (SLL) de réglage du décodeur, servant à illustrer le déroulement des processus de détermination de la valeur de réglage.

La description ci-après s'appuie sur un exemple où le signal est de type MAC, mais l'homme du métier peut facilement adapter le procédé et le dispositif pour les appliquer à tout autre type de signal comportant au moins des parties de signal numérique à plusieurs niveaux.

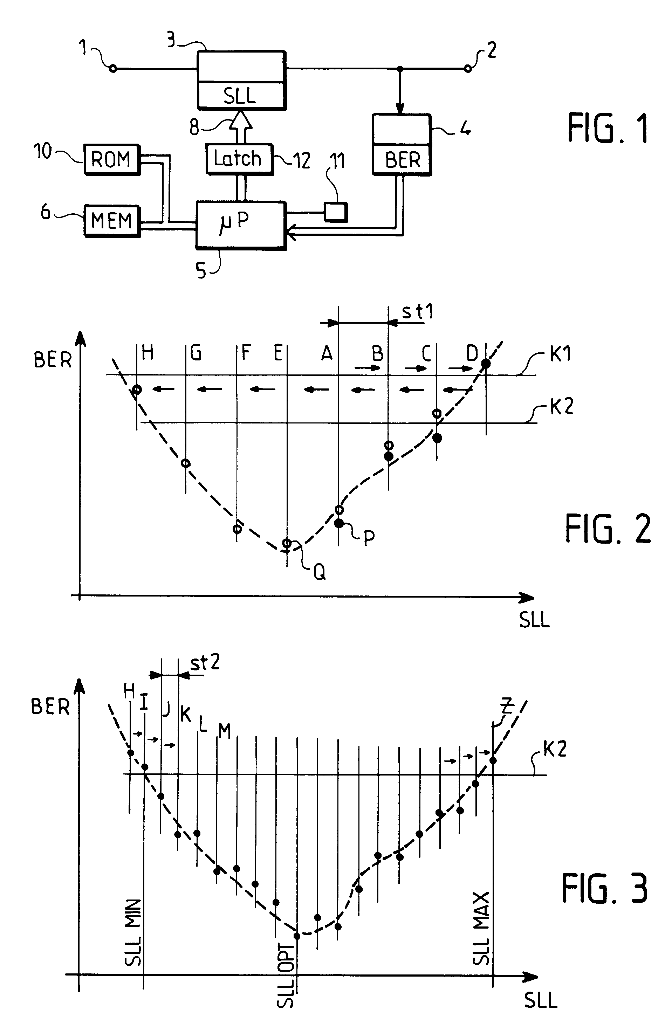

Le dispositif représenté sur la figure 1, qui fait partie d'un récepteur de télévision, comprend une entrée 1 à laquelle est appliqué un signal de télévision, par exemple de type MAC, qui est susceptible d'être affecté d'écho. Ce signal est amené à un décodeur 3 muni d'une entrée numérique de commande (par exemple à sept bits) pour établir une valeur de seuil dans le décodeur. Le signal décodé est fourni sur une sortie 2 et amené à un module 4 de mesure du taux d'erreur binaire muni d'une sortie 9 de résultat de mesure référencée BER. Un microprocesseur 5 muni d'une mémoire 6 pour enregistrer des valeurs transitoirement, peut calculer une valeur numérique à partir de la valeur de mesure lue sur la sortie 9 et fournir la valeur résultant du calcul sur une connexion 8 reliée à l'entrée numérique de commande de seuil qui est référencée SLL . Une mémoire 10 permanente contient une valeur de départ du seuil, et deux valeurs de pas d'incrémentation du seuil. Si l'on suppose par exemple que l'entrée de commande du seuil SLL est une entrée numérique à sept bits on peut choisir comme première valeur du pas d'incrémentation une valeur numérique égale à trois. Quant à la deuxième valeur du pas, elle sera de un bit.

La plupart des éléments qui sont représentés en tant qu'éléments discrets sur la figure 1 sont en pratique incorporés soit dans le microprocesseur soit dans le décodeur.

Le microprocesseur est chargé avec un programme qui calcule, à partir de plusieurs résultats de mesure fournis par lesdits moyens de mesure du taux d'erreur binaire, une valeur numérique de réglage du seuil du décodeur et fournit cette valeur numérique à ladite entrée numérique de commande. Ce programme entraine la mise en oeuvre des opérations décrites ci-après.

On suppose d'abord que la dégradation apportée est en dessous de celle qui rendrait inopérant le décodeur à seuil (impossibilité de se synchroniser), et que la perturbation par écho peut être considérée comme stationnaire (distribution par cable).

Lors d'une étape d'initialisation, le microprocesseur lit la valeur de départ du seuil (A, figure 2) dans la mémoire 10, il l'inscrit en mémoire 6 et la présente (par l'intermédiaire d'un circuit "latch" 12 pour maintenir la valeur) sur la connexion 8 pour établir ce seuil à l'entrée SLL du décodeur 3. Le module de mesure 4 compte les erreurs de mesure à partir des données numériques codées en code Golay, qui sont présentes dans les données MAC. Grâce au codage Golay, il est possible de savoir si les données reçues sont justes ou non. Par exemple le module de mesure compte (en les cumulant) les erreurs sur les données pendant une trame entière à chaque salve de données codées Golay, puis il mémorise la valeur cumulée trouvée avant d'être remis à zéro au début de la trame suivante. Du fait de cette mémorisation, une valeur de mesure est disponible en permanence. Comme la variance sur le résultat de la mesure du taux d'erreurs est assez grande, il est préférable d'en faire la moyenne sur un certain nombre de mesures, par exemple sur cinquante mesures. Le microprocesseur lit donc cinquante fois à intervalle de trame la valeur sur la sortie BER du module 4 et il en fait la moyenne : ceci prend environ deux secondes. Il inscrit cette moyenne dans la mémoire 6 en tant que valeur initiale du taux d'erreurs optimal.

A partir de la valeur du taux d'erreur binaire notée BER, il calcule et inscrit dans le mémoire 6 une valeur que l'on appelera CRITÈRE. Pour son calcul, la formule suivante est appliquée :

CRITÈRE = 2 ∗ ( BER + 5 )

(BER et CRITÈRE sont exprimés en millièmes de pour-cent)

Ainsi le critère est obtenu en ajoutant une première quantité fixe (ici : 5) à la valeur du taux d'erreur mesuré, et en multipliant le tout par une deuxième quantité fixe (ici : 2). La quantité ajoutée (ici : 5) qui est négligeable pour les forts taux d'erreurs, devient pour les taux faibles le facteur principal dans la somme ( BER + 5 ), et ainsi l'incidence des dispersions sur la mesure du taux d'erreur binaire est diminuée, ces dispersions étant d'autant plus fortes que le taux d'erreur binaire est faible. Par exemple pour un taux d'erreur binaire de $10^{-5}$, soit BER = 1, des résultats de mesure allant de zéro à 2 par exemple peuvent être obtenus mais le critère, lui, varie seulement entre 10 et 14, soit beaucoup moins. En outre, le coefficient multiplicateur par 2 a pour but de procurer une marge dans la comparaison entre le taux d'erreur binaire mesuré et le critère, afin d'éviter des résultats de comparaison aléatoires.

Le microprocesseur lit aussi, dans la mémoire 10, la première valeur du pas d'incrémentation et l'inscrit dans la mémoire 6. Il positionne un drapeau 11 qui est prévu pour noter si l'on change de sens d'incrémentation du seuil. La valeur de départ du seuil peut être par exemple la valeur standard prévue dans l'art antérieur pour le réglage du seuil.

Le microprocesseur passe ensuite au processus d'incrémentation : il incrémente d'un pas (st1, figure 2) la valeur du seuil dans la mémoire 6, et applique la nouvelle valeur (B, figure 2) sur la connexion 8, puis commence la mesure du taux d'erreur (par comptage et calcul de moyenne, comme décrit plus haut). Après le délai nécessaire pour cette mesure, le microprocesseur compare entre elles la valeur du taux d'erreur binaire mesuré et la valeur du taux d'erreur binaire optimal qui est en mémoire 6 et si la valeur du taux d'erreur binaire est inférieure au taux d'erreurs optimal, il réévalue le taux d'erreur optimal en mémoire 6 en lui donnant la valeur du taux d'erreur binaire mesuré à l'instant et à partir du nouveau taux d'erreur binaire optimal, il recalcule le critère, toujours avec la même formule, et le place en mémoire à la place du précédent. Si par contre le taux d'erreur binaire mesuré à l'instant est supérieur au taux d'erreur binaire optimal, le microprocesseur compare ce taux d'erreur binaire avec le critère, et s'il est plus petit que le critère, il ajoute la valeur de pas d'incrémentation à la précédente valeur du seuil (toutes deux lues dans la mémoire 6), il applique la nouvelle valeur du seuil par l'intermédiaire du "latch" 12 à la connexion 8 (ce qui conduit par exemple au point C, figure 2), et recommence la série d'opérations (mesure, comparaison) décrite ci-dessus, et ainsi de suite. Lorsqu'il arrive à la valeur de seuil indiqué par D, le taux d'erreur binaire mesuré (les valeurs de taux d'erreur binaire mesurées sont indiquées par des points noirs, avec leurs écarts, dûs aux dispersions, par rapport à la courbe théorique en pointillés), est plus grand que le critère : comme le drapeau 11 indique que l'on n'a pas encore rencontré cette situation, le microprocesseur change le signe de la première valeur de pas d'incrémentation dans la mémoire 6 et change l'état du drapeau 11, après quoi le processus continue comme avant mais dans l'autre sens, ce qui fait passer par les valeurs de seuil successivement : C, B, A, E, F, G, H (maintenant les valeurs de taux d'erreur binaire mesurées sont indiquées par des petits cercles). Il faut remarquer qu'en arrivant à la valeur de seuil E, le taux d'erreur binaire mesuré (Q) devient plus petit que le taux d'erreur binaire optimal considéré jusque là (P), et le remplace. Le critère réfrencé k1 qui était utilisé jusque là est également remplacé par un critère plus faible référencé k2. Lorsque le processus arrive au seuil H, le taux d'erreur binaire devient plus grand que le critère k2. Maintenant le drapeau 11 indique que l'on a déja changé de sens d'incrémentation une fois : alors le processus est arrêté et la valeur du seuil H enregistrée. On pourrait alors choisir comme valeur de réglage du seuil la demi-somme des deux valeurs de seuil respectivement au moment ou l'on a inversé le sens de l'incrémentation (D) et à l'arrêt de l'incrémentation (H).

Néanmoins, pour obtenir une meilleure précision, on préfère continuer avec un deuxième processus d'affinage de la valeur du seuil. Dans ce second processus, le microprocesseur lit la deuxième valeur du pas d'incrémentation (plus petite : par exemple un bit d'accroissement de la valeur numérique à chaque pas) dans la mémoire 10 et on la place en mémoire 6 à la place de la première. Le processus repart alors avec les autres valeurs précédentes inchangées (seuil H, critère k2), pour passer par les valeurs de seuil I, J, K, L , M etc (figure 3, où les valeurs de taux d'erreur binaire mesurées sont indiquées par des points noirs). Au moment du passage du seuil I au seuil J, le taux d'erreur binaire devient plus petit que le critère K2 et la valeur du seuil J est mémorisée. Au moment du passage au seuil Z, le taux d'erreur binaire devient à nouveau plus grand que le critère K2 : la valeur du seuil Z est mémorisée, et l'incrémentation s'arrête.

Dans une étape de conclusion, la valeur de réglage du seuil est calculée en faisant la demi-somme des susdites première et deuxième valeurs de seuil (J, Z) enregistrées dans la mémoire 6, et cette valeur de réglage est bien entendu appliquée à la connexion 8, et est en outre mémorisée avec référence à l'émission reçue par le décodeur au moment du réglage. A cet effet, le récepteur comprend des positions de mémoire permanente pour stocker des valeurs de réglage de seuil. Ainsi, les échos étant supposés stationnaires, chaque fois que l'on désire recevoir une autre émission, il suffit de rappeler en mémoire la bonne valeur du réglage réalisé précédemment pour cette émission.

## Revendications

1. Procédé pour le réglage du seuil d'un décodeur à seuil pour un signal à plusieurs niveaux, caractérisé en ce que, pour diminuer les nuisances dues à un signal d'entrée dans le décodeur affecté d'écho, on utilise un décodeur (3) dont la valeur du seuil est programmable, et on adapte le seuil de ce décodeur (3), en déterminant la meilleure valeur de seuil à partir de plusieurs résultats de mesure, fournis par des moyens (4) de mesure du taux d'erreur binaire en sortie du décodeur, et correspondant chacun à une valeur de seuil différente.

2. Procédé selon la revendication 1, caractérisé en ce que, partant d'une valeur déterminée du seuil (A), on mesure le taux d'erreur binaire correspondant et on calcule à partir de ce taux d'erreur binaire une valeur appelée critère (k1) et qui est supérieure au taux d'erreur binaire et que l'on mémorise, puis on incrémente la valeur du seuil du décodeur pas à pas (B, C, D) et à chaque pas on mesure le taux d'erreur binaire et on le compare au critère et s'il est plus petit que le critère on continue l'incrémentation alors que lorsque le taux d'erreur binaire devient pour la première fois (D) plus grand que le critère on mémorise la valeur du seuil et on inverse le sens de l'incrémentation (C, B, A, E, F, G, H) et enfin lorsque le taux d'erreur binaire devient pour la deuxième fois (H) plus grand que le critère, on arrête l'incrémentation en mémorisant la dernière valeur du seuil (H) et on choisit pour valeur de réglage du seuil la demi somme des deux valeurs de seuil respectivement au moment (D) ou l'on a inversé le sens de l'incrémentation et à l'arrêt de l'incrémentation.

3. Procédé selon la revendication 2, caractérisé en ce que lors de la mesure du taux d'erreur binaire au départ du processus, on mémorise sa valeur que l'on suppose pour l'instant être le taux d'erreur binaire optimal et qu'ensuite, à chaque pas d'incrémentation, on compare le taux d'erreur mesuré (BER) avec le taux d'erreur binaire optimal et si le taux d'erreur binaire mesuré est plus petit que le taux d'erreur binaire optimal on remplace en mémoire la valeur du taux d'erreur binaire optimal par la nouvelle valeur mesurée à l'instant et on recalcule et mémorise aussi un nouveau critère avant de continuer l'incrémentation.

4. Procédé selon la revendication 2, caractérisé en ce qu'on choisit comme valeur numérique de pas d'incrémentation du seuil une valeur supérieure au pas le plus fin prévu pour le décodeur.

5. Procédé selon l'une quelconque des revendications 2 à 4, caractérisé en ce qu'on met en oeuvre un deuxième processus analogue au premier, deuxième processus dans lequel on utilise comme critère le dernier critère (k2) calculé lors du premier processus et comme valeur de départ pour le seuil la dernière valeur du seuil (H) utilisée dans le premier processus, puis on incrémente la valeur du seuil du décodeur pas à pas avec un pas (st2) plus petit que lors du premier processus (st1) et à chaque pas on mesure le taux d'erreur binaire et on le compare au critère et lorsque (J) le taux d'erreur binaire devient plus petit que le critère on mémorise une première valeur qui est celle du seuil à cet instant (J) et lorsque (Z) le taux d'erreur binaire devient plus grand que le critère on arrête l'incrémentation en mémorisant une deuxième valeur qui est celle du seuil à cet instant (Z) et on choisit pour valeur de réglage du seuil la demi-somme des susdites première et deuxième valeurs de seuil.

6. Procédé selon la revendication 5, caractérisé en ce qu'on choisit comme valeur numérique de pas d'incrémentation du seuil la valeur la plus fine prévue pour le décodeur.

7. Procédé selon l'une quelconque des revendications 2 à 6, caractérisé en ce qu'on calcule le critère en ajoutant une première quantité fixe à la valeur du taux d'erreur mesuré, et en multipliant le tout par une deuxième quantité fixe.

8. Procédé selon l'une quelconque des revendications précédentes, caractérisé en ce qu'on mémorise la valeur de réglage trouvée pour chacune des émissions susceptibles d'être reçues par le décodeur.

9. Récepteur de télévision comportant des moyens (4) de mesure du taux d'erreur binaire présent à la sortie d'un décodeur(3), et un microprocesseur (5), caractérisé en ce qu'il est muni d'un décodeur à seuil avec une entrée numérique de commande (SLL) pour y établir une valeur de seuil, et en ce que le microprocesseur comporte un programme pour déterminer, à partir de plusieurs résultats de mesure, fournis par lesdits moyens de mesure (4) du taux d'erreur binaire et correspondant chacun à une valeur de seuil différente, une valeur numérique de réglage optimal du seuil du décodeur et pour la fournir à ladite entrée (SLL) numérique de commande.

10. Récepteur selon la revendication 9, caractérisé en ce qu'il comprend en outre des positions de mémoire permanente (ROM) pour stocker des valeurs de réglage de seuil.

**Patentansprüche**

1. Verfahren zur Regelung der Schwelle eines Schwellendecoders für ein Signal mit mehreren Pegeln, dadurch gekennzeichnet, daß zum Verringern der störenden Effekte durch ein echobehaftetes Eingangssignal in dem Decoder ein Decoder (3) verwendet wird, dessen Schwellenwert programmierbar ist, während die Schwelle des Decoders (3) angepaßt wird durch Bestimmung des besten Schwellenwertes auf Basis mehrerer Meßergebnisse, die durch Mittel (4) zum Messen der binären Fehlerrate an dem Ausgang des Decoders geliefert werden, wobei jedes Ergebnis einem anderen Schwellenwert entspricht.

2. Verfahren nach Anspruch 1, dadurch gekennzeichnet, daß ausgehend von einem bestimmten Schwellenwert (A) die entsprechende binäre Fehlerrate gemessen wird und auf Grund dieser binären Fehlerrate ein Wert, der als Kriterium (k1) bezeichnet wird und die binäre Fehlerrate überschreitet, berechnet und gespeichert wird, wonach der Schwellenwert des Decoders schrittweise (B, C, D) erhöht wird und die binäre Fehlerrate bei jedem Schritt gemessen und mit dem Kriterium verglichen wird und wenn diese Rate kleiner ist als das Kriterium wird die Erhöhung fortgesetzt, während der Schwellenwert gespeichert wird und die Richtung der Erhöhung (C, B, A, E, F, G, H) umgekehrt wird, wenn die binäre Fehlerrate das Kriterium das erste Mal (D) überschreitet und wobei zum Schluß die Erhöhung gestoppt wird durch Speicherung des letzten Schwellenwertes, wenn die binäre Fehlerrate das Kriterium zum zweiten Mal (H) überschreitet, während die halbe Summe der zwei Schwellenwerten zu dem Zeitpunkt, wo die Erhöhungsrichtung umgekehrt wird und zu dem Zeitpunkt (D), wo die Erhöhung angehalten wird, als Schwellensteuerwert gewählt wird.

3. Verfahren nach Anspruch 2, dadurch gekennzeichnet, daß wenn bei der Messung der binären Fehlerrate am Anfang des Prozesses der Wert, der als die optimale binäre Fehlerrate vorausgesetzt wird, gespeichert wird, und wenn danach bei jedem Erhöhungsschritt die gemessene binäre Fehlerrate (BER) mit der optimalen binären Fehlerrate verglichen wird und wenn die gemessene binäre Fehlerrate kleiner ist als die optimale binäre Fehlerrate der Wert der optimalen binären Fehlerrate in dem Speicher durch den neuen aktuell gemessenen Wert ersetzt wird und ebenfalls ein neues Kriterium neu berechnet und gespeichert wird bevor die Erhöhung fortgesetzt wird.

4. Verfahren nach Anspruch 2, dadurch gekennzeichnet, daß ein Wert, der den letzten Schritt durch den Decoder überschreitet, als digitaler Wert des Schwellenerhöhungsschrittes gewählt wird.

5. Verfahren nach einem der Ansprüche 2 bis 4, dadurch gekennzeichnet, daß ein zweiter Prozeß analog zu dem ersten Prozeß durchgeführt wird, wobei in diesem zweiten Prozeß als Kriterium das während des ersten Prozesses als letztes Kriterium (k2) berechnete Kriterium benutzt wird und wobei der letzte Schwellenwert (H) aus dem ersten Prozeß benutzt wird als Ausgangswert für die Schwelle, wonach der Schwellenwert des Decoders schrittweise erhöht wird und zwar mit einem Schritt (st2), der kleiner ist als der der während des ersten Prozesses (st1) verwendet wurde und wobei die binäre Fehlerrate bei jedem Schritt gemessen und mit dem Kriterium verglichen wird und wenn (J) die binäre Fehlerrate kleiner wird als das Kriterium ein erster Wert gespeichert wird, der der Wert der Schwelle zu diesem bestimmten Zeitpunkt (J) ist und wenn (Z) die binäre Fehlerrate das Kriterium überschreitet, die Erhöhung dadurch beendet wird, daß ein zweiter Wert gespeichert wird, der der Wert der Schwelle zu diesem genannten Zeitpunkt (Z) ist und wobei die halbe Summe des obengenannten ersten und zweiten Schwellenwertes als Schwellensteuerwert gewählt wird.

6. Verfahren nach Anspruch 5, dadurch gekennzeichnet, daß der letzte Wert vom Decoder als digitaler Wert des Schwellenerhöhungsschrittes gewählt wird.

7. Verfahren nach einem der Ansprüche 2 bis 6, dadurch gekennzeichnet, daß das Kriterium dadurch berechnet wird, daß eine erste feste Menge des Wertes der gemessenen Fehlerrate addiert und das Ganze mit einer zweiten festen Menge multipliziert wird.

8. Verfahren nach einem der vorstehenden Ansprüche, dadurch gekennzeichnet, daß der gefundene Steuerwert gespeichert wird und zwar bei jeder Übertragung die von dem Decoder empfangen werden kann.

9. Fernsehempfänger mit Mitteln (4) zum Messen der binären Fehlerrate an dem Ausgang des Decoders (3) und mit einem Mikroprozessor (5), dadurch gekennzeichnet, daß er mit einem Schwellendecoder versehen ist mit einem digitalen Steuereingang (SLL) zum Zuführen eines Schwellenwertes zu demselben und daß der Mikroprozessor mit einem Programm geladen ist, das auf Basis mehrerer Meßergebnisse durch die genannten Mittel (4) zum Messen der binären Fehlerrate und je entsprechend einem anderen Schwellenwert, einen digitalen Wert für die optimale Steuerung der Schwelle des Decoders bestimmt und den genannten digitalen Wert dem genannten digitalen Steuereingang (SLL) zuführt.

10. Empfänger nach Anspruch 9, dadurch gekennzeichnet, daß er außerdem Festwertspeicherstellen (ROM) zum Speichern von Schwellensteuerwerten enthält.

**Claims**

1. A method of controlling the threshold of a threshold decoder for a signal having several levels, characterized in that, for reducing the harmful effects due to an echo-affected input signal in the decoder, a decoder (3) is used whose threshold value is programmable, while the threshold of the decoder (3) is adapted by determining the best threshold value on the basis of several measuring results provided by means (4) for measuring the binary error rate at the output of the decoder, each result corresponding to a different threshold value.

2. A method as claimed in Claim 1, characterized in that, starting from a given threshold value (A), the corresponding binary error rate is measured and, based on said binary error rate, a value which is referred to as criterion (k1) and exceeds the binary error rate is computed and stored, whereafter the threshold value of the decoder is incremented step by step (B,C,D) and the binary error rate is measured at each step and compared with the criterion, and if said rate is smaller than the criterion, the incrementation is continued, while the threshold value is stored and the direction of incrementation (C,B,A,E,F,G,H) is reversed when the binary error rate exceeds the criterion for the first time (D), and finally the incrementation is stopped by storing the last threshold value (H) when the binary error rate exceeds the criterion for the second time (H), while half the sum of the two threshold values at the instant (D) of reversing the direction of incrementation and at the instant of stopping the incrementation, respectively, is chosen as the threshold control value.

3. A method as claimed in Claim 2, characterized in that, during measurement of the binary error rate at the start of the process, its value which is tentatively supposed to be the optimal binary error rate is stored and in that subsequently at each incrementation step the measured binary error rate (BER) is compared with the optimal binary error rate, and if the measured binary error rate is smaller than the optimal binary error rate, the value of the optimal binary error rate is replaced in the memory by the new value actually measured and also a new criterion is recomputed and stored before continuing the incrementation.

4. A method as claimed in Claim 2, characterized in that a value which is higher than the last step provided by the decoder is chosen as the digital value of the incrementation step.

5. A method as claimed in any one of Claims 2 to 4, characterized in that a second process analogous to the first is performed, in which second process the last criterion (k2) computed during the first process is used as a criterion and the last threshold value (H) used in the first process is used as the starting value for the threshold, whereafter the threshold value of the decoder is incremented step by step with a step (st2) which is smaller than that used during the first process (st1), and the binary error rate is measured at each step and compared with the criterion, and when (J) the binary error rate becomes smaller than the criterion, a first value is stored which is the value of the threshold at said instant (J), and when (Z) the binary error rate exceeds the criterion, the incrementation is stopped by storing a second value which is the value of the threshold at said instant (Z), and half the sum of the above-mentioned first and second threshold values is chosen as the threshold control value.

6. A method as claimed in Claim 5, characterized in that the last value provided by the decoder is chosen as the digital value of the threshold incrementation step.

7. A method as claimed in any one of Claims 2 to 6, characterized in that the criterion is computed by adding a first fixed quantity to the value of the measured error rate and by multiplying the total by a second fixed quantity.

8. A method as claimed in any one of the preceding Claims, characterized in that the control value found at each transmission which can be received by the decoder is stored.

9. A television receiver comprising means (4) for measuring the binary error rate at the output of a decoder (3), and a microprocessor (5), characterized in that it is provided with a threshold decoder having a digital control input (SL) for applying a threshold value thereto, and in that the microprocessor is loaded with a program which, based on several measuring results provided by said means (4) for measuring the binary error rate and each corresponding to a different threshold value, determines a digital value for optimally controlling the threshold of the decoder and applies said digital value to said digital control input (SLL).

10. A receiver as claimed in Claim 9, characterized in that it also includes permanent-memory sites (ROM) for storing the threshold control values.

FIG. 1

FIG. 2

FIG. 3